# EUROPEAN PATENT SPECIFICATION

(11) **EP 0 547 989 B1**
(45) Date of publication and mention of the grant of the patent: **31.03.1999**
(21) Application number: 92480171.5
(22) Date of filing: 19.11.1992
(51) Int. Cl.: H01L 23/556

(54) **Alpha particle disturb reduction techniques**
Technik zum Reduzieren von Störungen durch Alphateilchen
Technique pour la réduction des dérangements générés par particules alpha

(30) Priority: 17.12.1991 US 809357
(43) Date of publication of application: 23.06.1993
(73) Proprietor: International Business Machines Corporation, Armonk, N.Y. 10504 (US)
(72) Inventor: Chidambarrao, Dureseti, Derby, Connecticut 06418 (US); Nijhuis, Rolf Henk, Pleasant Valley, New York 12569 (US); Srinivasan, Gurumakonda Ramasamiengar, Poughkeepsie, New York 12603 (US); Murley, Philip Clyde, Poughkeepsie, New York 12601 (US); Robbins, Gordon Jay, Wappingers Falls, New York 12590 (US); Walters, Timothy Lawton, Poughkeepsie, New York 12601 (US)
(74) Representative: Klein, Daniel Jacques Henri

(56) References cited:
- EP-A- 0 363 297
- US-A- 4 541 003
- PATENT ABSTRACTS OF JAPAN vol. 13, no. 486 (E-840)6 November 1989 & JP-A-1 194 443 ( HITACHI LTD )
- IBM TECHNICAL DISCLOSURE BULLETIN. vol. 23, no. 8, January 1981, NEW YORK US page 3599 W.T. MOTSIFF ET AL. 'Alpha ParticleShielding Processes'
- IBM TECHNICAL DISCLOSURE BULLETIN. vol. 22, no. 4, September 1979, NEW YORK US pages 1460 - 1461 J.A. BRODY ET AL. 'Storage and Logic Errors in Dynamic Memory Devices Due to Innate Radioactive Materials in Packaging and Wafer'

## Description

The invention relates generally to methods and apparatus for reducing and/or minimizing soft errors caused by alpha particle radiation generated from within semiconductor modules of the type comprising a semiconductor device (e.g., integrated circuit) sealed in a package made, for example, of a ceramic; where a lead/tin pad (such as a C4 flip-chip contact) is located within the sealed semiconductor module and is in electrical contact with the semiconductor device. More particularly, the invention relates to methods and apparatus which minimize the potential for soft errors caused by alpha particle radiation generated by the contact, by impurities in the chip package itself and/or by certain other constituents of the semiconductor module, such as package sealing members made of low melting point glass.

The aforementioned methods and apparatus are particularly useful in connection with high density/high performance integrated circuits which cannot be easily modified (without affecting circuit performance or cost), to mitigate the affects of alpha particle radiation on, for example, switching transistors, latches, etc., included in such circuits. The invention also relates to processes for manufacturing semiconductor modules incorporating the novel methods and apparatus set forth herein.

Many prior art techniques are known for reducing the susceptibility of semiconductor devices, such as memory devices, latches and the like, to alpha radiation. Such radiation is known to naturally occur as a result of the radioactive decay of uranium (U) and thorium (Th) found in certain semiconductor module components such as, for example, contact pads comprised of a lead/tin solder, ceramic packaging material and package sealants made of low melting point glass.

When alpha rays thus produced intrude into the semiconductor device, pairs consisting of a positive hole and an electron are generated and either the positive hole or the electron of each pair is collected into the active region of the semiconductor device and can cause, for example, the destruction of stored information where the semiconductor device is a memory, latch, etc. Accordingly, it is important to reduce and whenever possible minimize irradiation and intrusion of alpha rays into the active region of a semiconductor device, particularly from sources close to said active area, such as contact pads, etc.

An example of a prior art teaching pertaining to the protection of semiconductor devices from alpha radiation is set forth in Abiru et al, US-A-4426657. Abiru et al teaches the use of a protective polyimide film layer to prevent alpha rays from intruding into a semiconductor device.

According to Abiru et al, the polyimide film layer is formed on at least one region where the semiconductor element is formed, by coating the semiconductor substrate with a liquid polyimide or polyamic acid composition having incorporated therein finely divided filler particles, according to a screen printing method.

Although Abiru et al teaches a technique for preventing harmful alpha rays from intruding into a semiconductor device; this prior art reference fails to prevent such particles that emanate from within the chip itself, for example, the bottom of contact pads (such as a C4 flip-chip solder ball) on a chip. Such contact pads are known to be large generators of alpha particles that can disturb circuits on a chip.

Another example of a prior art teaching of an alpha particle shield is set forth in Otsuka et al, in USA-4541003. The alpha particle shield taught in the Otsuka et al reference is interposed between an alpha particle emitting resin and the active area of a semiconductor device. However, Otsuka et al, like Abiru et al, fails to teach, claim or even suggest how to shield the active area of a semiconductor device from alpha radiation emanating from within the chip itself, for example, from a contact pad alpha particle source (such as a lead/tin C4 contact).

A further example of an alpha particle shield is discussed in the article of J.A. Brody et al.: "Storage and logic errors in dynamic memory devices due to innate radioactive materials in packaging and wafer", published in IBH Technical Disclosure Bulletin, vol. 22, No. 4, pages 1460-1461.

Other known techniques for desensitizing circuitry to the effects of alpha particles include operating the circuit in saturation and/or adding capacitor circuit elements as taught by Iizuka et al in US-A-4641165. Such techniques are not alpha barrier oriented and require changes in the circuitry being protected at the expense of performance, cost, power requirements and chip size.

With the advent of increasingly smaller geometries of semiconductor chips, the circuits fabricated thereon will become even more sensitive to alpha particle disturbs while performance requirements increase. These circumstances make the "circuit type" alpha particle protection solutions increasingly unattractive and impractical.

In addition to the teachings of Otsuka et al, still other alpha particle radiation shields are known that are specifically directed to mitigating the effects of alpha rays emanating from packaging materials and sealants. Such techniques are taught for example in Suzuki et al in US-A-4494217; and Sono, US-A- 4661837, respectively. Like the other references cited hereinabove, neither Suzuki et al nor Sono contemplate providing protection from alpha rays emanating from contact pads while at the same time providing protection from packaging materials, sealants and the like.

Further still, there exist prior art teachings directed to increasing the size of a dielectric coating on a semiconductor device to mitigate alpha radiation effects. Such teachings are set forth, for example, in Japanese Patents JP-A-1-36063, JP-244050 and JP-148852; but like the other prior art references discussed hereinbefore, these patents fail to teach, claim or even suggest how to prevent alpha radiation generated by lead/tin contact pads from adversely affecting a semiconductor device. In fact, these patents exemplify teachings away from the invention to be set forth hereinafter, by using only non-conductive dielectric coatings as alpha particle barriers.

A semiconductor device carrying an insulating layer with conductive studs therein is described in EP-A-0 363 297.

Accordingly, in view of the prior art, it would be desirable to be able to provide methods and apparatus which mitigate the effects of alpha radiation generated by contact pads in particular, as well as alpha radiation generated by other alpha sources in close proximity to semiconductor devices located within a semiconductor module.

Furthermore, in view of the state of the art, it would be desirable to be able to provide techniques for mitigating the effects of alpha radiation in semiconductor modules that do not require the addition of circuit elements, degrade circuit performance, or increase circuit cost.

Still further, it would be desirable to be able to provide the aforementioned methods, apparatus and techniques in semiconductor modules which can be fabricated utilizing existing integrated circuit processes and which do not require new package processes for manufacturing such modules.

Further yet, it is desirable to provide methods and apparatus for mitigating the effects of alpha radiation in semiconductor modules which enhance the prospects for being able to increase circuit density and improving circuit performance, through the use of techniques that do not interfere with these circuit characteristics.

Accordingly, it is an object of the invention to provide methods and apparatus which mitigate the effects of alpha radiation generated by contact pads and other alpha sources in close proximity to semiconductor devices located within a semiconductor module.

Furthermore, it is an object of the invention to implement such methods and apparatus utilizing techniques that do not require the addition of circuit elements, that do not degrade circuit performance, or increase circuit cost.

Still further, it is an object of the invention to provide techniques for mitigating the effects of alpha radiation in semiconductor modules which can be fabricated without having to develop new silicon or packaging processes.

Further yet, it is an object of the invention to provide methods and apparatus which reduce the effects of alpha radiation in semiconductor modules while not impacting circuit density, power requirements and/or circuit performance; and which in fact facilitate improvements in these areas by not interfering with these circuit characteristics.

Still another object of the invention is to provide an alpha particle shield that combines (1) the properties of an electrically insulative alpha barrier with (2) the properties of an electrically conductive alpha particle absorbing material, in order to separate a contact from the metal layers of a semiconductor device (via the shield), to thereby increase the distance between the contact (a significant alpha particle source) and the active area of the semiconductor device, and at the same time provide an electrical path between the contact and the aforesaid metal layers of the semiconductor device.

In addition to the aforestated objectives, it is also an objective of the invention to provide manufacturing techniques which may be utilized to fabricate semiconductor modules that realize each of the aforestated objectives.

According to the invention as set out in the appended claims, methods, apparatus and manufacturing techniques are set forth which take advantage of the attenuation effects of well known alpha particle barriers, such as quartz or polyimide insulators; and electrically conductive studs, such as studs made of copper, which also absorb alpha particles. These methods, apparatus and related manufacturing techniques are all designed to increase the vertical distance between an alpha particle source, such as a lead/tin C4 pad, and the silicon surface where the active area of an integrated circuit is located.

According to one aspect of the invention, if the distance can be made large enough, with an alpha particle absorbing material being interposed between an alpha source and a semiconductor device, then very significant alpha particle immunity can be achieved for the semiconductor device.

In particular, according to one embodiment of the invention, an integrated circuit chip is set forth having reduced semiconductor device susceptibility to alpha particle induced soft errors in a semiconductor module that includes at least one alpha particle source and at least one semiconductor device, wherein said at least one alpha particle source includes at least one Pb/Sn C4 contact pad in electrical contact with the metal layers of said semiconductor device; said integrated circuit chip comprising :
(a) insulation layer whose thickness is between 40 µm and 50 µm to provide an effective alpha particle barrier between said at least one alpha particle source and at least one active area of said semiconductor device; and
(b) a conductive stud embedded in said insulation layer made of a material providing an alpha particle absorbing conductive path between said at least one contact C4 pad located on one side of said barrier and the metal layers of said semiconductor device located on the other side of said alpha particle barrier.

According to a preferred embodiment of the invention, where a lead/tin C4 contact pad is used in the semiconductor module, the invention contemplates the use of a quartz or polyimide alpha particle barrier (as an example of the aforesaid insulation means), and the use of a cylindrical copper stud inserted through the barrier provided by said insulation means, to provide an electrically conductive path between the C4 pad located on one side of the barrier and the metal layers of the semiconductor device located on the other side of the barrier.

As indicated hereinabove, an aspect of the invention is also directed to a manufacturing process that may be used to realize and implement the aforementioned apparatus. In particular, according to the invention, a semiconductor module manufacturing process is set forth which provides protection for the active area of semiconductor devices included within said module, comprising the steps of: (a) drilling at least one hole in an insulation layer of an electrically insulative material to provide an effective alpha particle barrier between said at least one alpha particle source, including at least one contact pad, and said active area of a semiconductor device; and (b) filling each of said at least one hole with an electrically conductive stud of a material that has the property of absorbing alpha particles to provide an electrical path between said contact pad in contact with one end of said stud and the metal layers of said semiconductor device located on the other end of said stud on the opposite side of said barrier.

Further features of the invention include the ability to use conventional sources of lead to fabricate contacts, and the ability to provide the aforementioned features without having to add circuit elements, degrade circuit performance, etc.

These and other objects and features of the invention will be recognized by those skilled in the art upon reviewing the detailed description set forth hereinafter in conjunction with the accompanying Drawing.

FIG. 1 depicts a cross section of a prior art semiconductor module that includes a lead/tin C4 contact pad in direct contact with the metal layers of a semiconductor device contained within said module.

FIG. 2 depicts a cross section of a semiconductor module fabricated in accordance with the teachings of the invention.

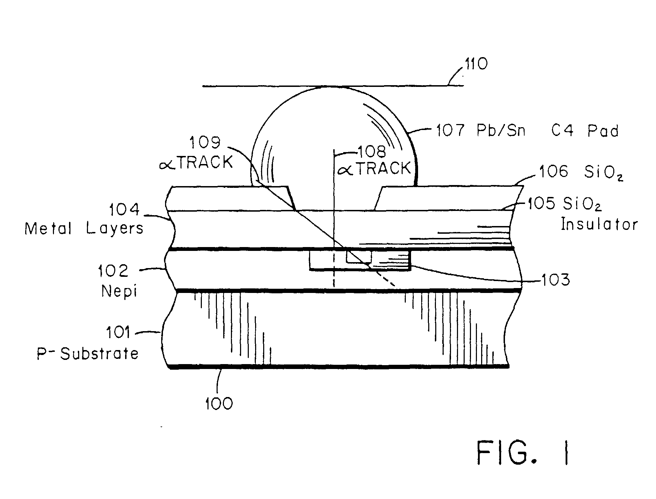

As indicated hereinabove, FIG. 1 depicts a cross section of a prior art semiconductor module that includes a lead/tin C4 contact pad in direct contact with the metal layers of a semiconductor device contained within said module.

In particular, FIG. 1 shows a semiconductor module 100, comprising a p-type substrate, 101, on which, for example, an n-type silicon layer 102 (such as an n-type epitaxy) is shown deposited. Processes for depositing n-type layer 102 on a substrate, such as substrate 101, are well known to those skilled in the art and include, for example, chemical vapor deposition techniques.

FIG. 1 also shows, for the sake of illustration only, transistor 103 deposed onto silicon layer 102. Well known techniques also exists for fabricating, etching, depositing, etc., semiconductor devices, such as the one exemplified by transistor 103, and complete integrated circuits into layer 102 and accordingly such techniques will not be discussed further herein.

The cross section of the semiconductor module shown in FIG. 1 also includes a depiction of the metal layers of the semiconductor device, layer(s) 104, and an exemplary electrical insulator, shown as quartz insulator 105, covering silicon epilayer 102. A well known type of alpha particle barrier is also shown in FIG. 1 as barrier 106. For the sake of illustration only, alpha particle barrier 106 is depicted as a 3 micron layer of electrically insulative material, such as quartz or a polyimide, covering metal layer(s) 104 and insulator 105. The approximately 3 micron layer of alpha absorption material shown in FIG. 1, is a common order of magnitude thickness for an absorber such as layer 106.

A window through alpha barrier 106 is shown, which enables the depicted lead/tin C4 contact pad, pad 107, to be affixed to metal layer(s) 104 as is conventionally done to facilitate electrical communication between the "outside world" and the semiconductor device.

FIG. 1 also shows a portion of a ceramic cover, 110, in contact with contact 107, together with alpha particle tracks 108 and 109, indicating vertical and angular alpha tracks respectively that said alpha particles can take to adversely affect the performance of a semiconductor device, such as transistor 103.

It should be noted that damaging alpha particles can impinge on the front of a chip (from the direction of depicted C4 pad 107). As these particles travel through the chip at high velocity, losing energy to the surrounding material, a wake of hole-electron pairs (as indicated hereinbefore) is left in the silicon. The minority carriers generated near a p-n junction can move by drift and diffusion and if near exemplary transistor 103, this may lead to a false switching.

According to one embodiment of the invention, advantage is taken of the alpha particle attenuation effects of polyimide insulators and electrically conducting copper studs, to alleviate the alpha particle disturb problem set forth hereinabove. In particular, the problem can be mitigated by increasing the vertical distance between the exemplary lead/tin C4 pad shown in FIG. 1 (as pad 107) and the silicon surface (102) where exemplary transistor 103 is located. If this distance is made large enough, then very significant alpha particle immunity will be realized (by several orders of magnitude), without adding circuit components to the semiconductor device, without degrading circuit performance or increasing device cost, etc... but this is at the cost of inventing a new contact metallurgy scheme.

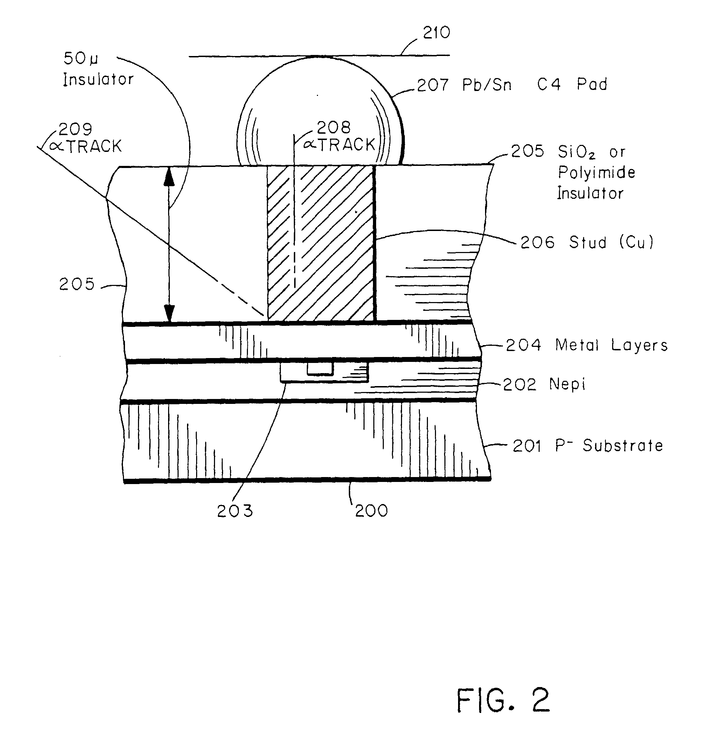

Reference should now be made to FIG. 2 which depicts a cross section of a semiconductor module, module 200, fabricated in accordance with the teachings of the invention.

FIG. 2 shows an illustrative embodiment of the invention in which increased separation between a contact (such as the depicted C4 contact 207), and silicon surface 201 (including an active area, with the active area being represented in FIG. 2 by transistor 203), is accomplished by thickening the top layer insulator (205) of the chip. This "thickening" and "increased separation" shown in FIG. 2 is of course relative with respect to the size of barrier 106 shown in FIG. 1 (the 3 µm barrier). More objectively, the separation contemplated by the invention is one that distances the C4 contact itself from the metal layers of the semiconductor device.

Accordingly, whereas pad 107 in FIG. 1 is shown to be in direct contact with metal layer(s) 104; in FIG. 2, contact 207 is shown separated from metal layer(s) 204 via an electrically conducting stud, such as copper stud 206. This separation "increases" the distance between the contact and the metal layers and thus increases the vertical distance between the contact and the active area of the chip.

For the sake of completeness, FIG. 2 also shows p-type material 201, n-type material 202 (like materials 101 and 102 shown respectively in FIG. 1); alpha tracks 208 and 209; and ceramic cap 210, in contact with pad 207.

The dashed lines at the ends of the alpha tracks shown within insulator 205 and within stud 206, are meant to show the absorption of alpha particles following the depicted tracks, with the absorption taking place before the particles have a chance to disturb transistor 203.

Dimensionally, the top insulator (for example, a quartz or polyimide barrier between the contact pad and top layer metal), on the order of approximately 40-50 µm (versus a typical barrier of 2-3 µm as shown in FIG. 1), exhibits significant alpha particle absorption characteristics to prevent the damaging alpha particles that emanate from the contact itself (and follow a vertical track, like track 208), from adversely affecting the semiconductor device. Separation of pad 207 from the semiconductor device via the use of stud 206 is also effective in increasing the distance between ceramic cover 210 and the device, further protecting the device from alpha rays emanating from portions of the ceramic package (and from any sealants used) located on the opposite side of the barrier with respect to the semiconductor device.

According to a manufacturing process contemplated by the invention, in order to fabricate the module depicted in FIG. 2 the standard "final vias" (holes) through the electrically insulative alpha particle barrier (e.g., the window shown in layer 106 of FIG. 1 where contact pad 107 is affixed to metal layer(s) 104), must be replaced by electrically conductive studs which traverse barrier 205 as shown in FIG. 2, so as to connect the lead/tin contact pad down to the top layer metal. According to one manufacturing process contemplated by the invention, this "replacement" is accomplished by drilling holes through the thick insulation layer, like layer 205 shown in FIG. 2 (for example, by RIE), and then filling the holes (for example, by plating) with electrically conducting studs, like copper stud 206, to allow electrical communication between a pad (like pad 207) and metal layer(s) 204.

Experiments indicate that the use of a "final stud", having a height and cross section of approximately 50 µm (i.e., a cubic 50 µm stud), if made of copper, has a resistance of 0.5 x 10⁻³ Ohms and a capacitance of 0.02 x 10⁻¹² Farads, which are acceptable values for even high performance chips.

With the illustrated vertical separation of the contact pads and semiconductor devices increased to approximately 50 µm as shown in FIG. 2, several improvements occur. First, for both lead/tin pads (C4 or other type pads) and ceramic packages, alpha particle effects on circuits are nearly eliminated due to the absorbing effects of the thickened top insulators (between an alpha source and silicon devices). Secondly, with alpha particle immunity significantly improved by application of the invention, additional circuit elements or high capacitance component profiles are not required to maintain, in the case of transistors, Q_{crit}. Hence, Q_{crit} can be decreased resulting in the potential for smaller devices/circuits, increased circuit density, lower circuit/chip power requirements, and improved performance.

The 50 µm example for stud cross section was set forth for the purposes of illustration only and the results obtainable utilizing such a stud (in particular the exemplary cubic copper stud) are merely meant to illustrate the improvements that can be realized in alpha particle protection by utilizing combinations of various insulators and electrically conductive materials (both of which absorb alpha particles) to separate and form a barrier between alpha particle sources (including a contact pad), and active areas of a semiconductor device.

What has been described in detail hereinabove are methods and apparatus meeting all of the aforestated objectives. As previously indicated, those skilled in the art will recognize that the foregoing description has been presented for the sake of illustration and description only. It is not intended to be exhaustive or to limit the invention to the precise form disclosed, and obviously many modifications and variations are possible in light of the above teaching, the scope of the invention being determined by the appended claims.

## Claims

1. Integrated circuit chip having reduced semiconductor device susceptibility to alpha particle induced soft errors in a semiconductor module that includes at least one alpha particle source and at least one semiconductor device (203), wherein said at least one alpha particle source includes at least one Pb/Sn C4 contact pad (207) in electrical contact with the metal layers (204) of said semiconductor device; said integrated circuit chip comprising:
(a) an insulation layer (205) whose thickness is between 40 µm and 50 µm to provide an effective alpha particle barrier between said at least one alpha particle source and at least one active area of said semiconductor device; and,
(b) a conductive stud (206) embedded in said insulation layer made of a material providing an alpha particle absorbing electrically conductive path between said at least one contact C4 pad located on one side of said barrier and the metal layers of said semiconductor device located on the other side of said alpha particle barrier.

2. Integrated circuit chip as set forth in claim 1 wherein said at least one alpha particle source further includes ceramic semiconductor packaging material.

3. Integrated circuit chip as set forth in claim 1 wherein said at least one alpha particle source further includes a semiconductor module sealant.

4. Integrated circuit chip as set forth in any above claim wherein the material forming said conductive stud consists essentially of copper.

5. Integrated circuit chip as set forth in any above claim wherein the material forming said insulation layer consists essentially of quartz or polyimide.

6. Integrated circuit chip as set forth in claim 5 wherein the thickness of said insulation layer is 50µm.

7. A process for manufacturing a semiconductor module that provides protection for the active area of a semiconductor device included within said module, comprising the steps of:
(a) drilling at least one hole in an insulation layer of an electrically insulative material, whose thickness is between 40 µm to 50 µm to provide an effective alpha particle barrier between said at least one alpha particle source, including at least one contact pad, and said active area of a semiconductor device; and,
(b) filling each of said at least one hole with an electrically conductive stud of a material that has the property of aborbing alpha particles to provide an electrical path between said contact pad in contact with one end of said stud and the metal layers of said semiconductor device located on the other end of said stud on the opposite side of said barrier.

8. A process as set forth in claim 7 wherein said electrically conductive stud consists essentially of copper.

9. A process as set forth in claim 7 or 8 wherein said electrically insulative material that absorbs alpha particles consists essentially of quartz or polyimide.

10. A process as set forth in claim 9 wherein the thickness of said insulation layer is 50µm.

## Patentansprüche

1. Integrierter Schaltkreis-Chip mit reduzierter Empfindlichkeit des Halbleiterbauelements gegenüber durch Alphateilchen induzierten Fehlern in einem Halbleitermodul, das wenigstens eine Alphateilchenquelle und wenigstens ein Halbleiterbauelement (203) beinhaltet, wobei die wenigstens eine Alphateilchenquelle wenigstens einen Pb/Sn-C4-Kontaktfleck (207) in elektrischem Kontakt mit den Metallschichten (204) des Halbleiterbauelements aufweist; wobei der integrierte Schaltkreis-Chip beinhaltet:
(a) eine Isolationsschicht (205), deren Dicke zwischen 40 µm und 50 µm liegt, um eine effektive Alphateilchenbarriere zwischen wenigstens einer Alphateilchenquelle und wenigstens einem aktiven Gebiet des Halbleiterbauelements bereitzustellen; und
(b) einen leitfähigen Stift (206), der in der Isolationsschicht eingebettet ist und aus einem Material besteht, das einen Alphateilchen absorbierenden, elektrisch leitfähigen Pfad zwischen dem wenigstens einen C4-Kontaktfleck, der sich auf einer Seite der Barriere befindet, und den Metallschichten des Halbleiterbauelements bereitstellt, die sich auf der anderen Seite der Alphateilchenbarriere befinden.

2. Integrierter Schaltkreis-Chip, wie in Anspruch 1 dargelegt, wobei die wenigstens eine Alphateilchenquelle des weiteren keramisches Halbleiterpackungsmaterial beinhaltet.

3. Integrierter Schaltkreis-Chip, wie in Anspruch 1 dargelegt, wobei die wenigstens eine Alphateilchenquelle des weiteren eine Halbleitermodul-Dichtungsmasse beinhaltet.

4. Integrierter Schaltkreis-Chip, wie in irgendeinem obigen Anspruch dargelegt, wobei das Material, das den leitfähigen Stift bildet, im wesentlichen aus Kupfer besteht.

5. Integrierter Schaltkreis-Chip, wie in irgendeinem obigen Anspruch dargelegt, wobei das Material, das die Isolationsschicht bildet, im wesentlichen aus Quarz oder Polyimid besteht.

6. Integrierter Schaltkreis-Chip, wie in Anspruch 5 dargelegt, wobei die Dicke der Isolationsschicht 50 µm beträgt.

7. Verfahren zur Herstellung eines Halbleitermoduls, das einen Schutz für das aktive Gebiet eines in dem Modul enthaltenen Halbleiterbauelements bereitstellt und das die Schritte umfaßt:
(a) Bohren von wenigstens einem Loch in eine Isolationsschicht aus einem elektrisch isolierenden Material, deren Dicke zwischen 40 µm und 50 µm liegt, um eine effektive Alphateilchenbarriere zwischen der wenigstens einen Alphateilchenquelle, die wenigstens einen Kontaktfleck beinhaltet, und dem aktiven Gebiet eines Halbleiterbauelements bereitzustellen; und
(b) Füllen von jedem des wenigstens einen Loches mit einem elektrisch leitfähigen Stift aus einem Material, das die Eigenschaft aufweist, Alphateilchen zu absorbieren, um einen elektrischen Pfad zwischen dem Kontaktfleck in Kontakt mit einem Ende des Stiftes und den Metallschichten des Halbleiterbauelements bereitzustellen, die sich am anderen Ende des Stiftes auf der entgegengesetzten Seite der Barriere befinden.

8. Verfahren, wie in Anspruch 7 dargelegt, wobei der elektrisch leitfähige Stift im wesentlichen aus Kupfer besteht.

9. Verfahren, wie in Anspruch 7 oder 8 dargelegt, wobei das elektrisch isolierende Material, das Alphateilchen absorbiert, im wesentlichen aus Quarz oder Polyimid besteht.

10. Verfahren, wie in Anspruch 9 dargelegt, wobei die Dicke der Isolationsschicht 50 µm beträgt.

## Revendications

1. Puce de circuit intégré possédant un dispositif à semiconducteurs à sensibilité réduite aux erreurs de logiciel induites par les particules alpha dans un module à semiconducteurs qui comporte au moins une source de particules alpha et au moins un dispositif à semiconducteurs (203), dans lequel ladite au moins une source de particules alpha comporte au moins un plot de contact Pb/Sn C4 (207) en contact électrique avec les couches métalliques (204) dudit dispositif à semiconducteurs, ladite puce de circuit intégré comportant :
(a) une couche d'isolement (205) dont l'épaisseur se situe entre 40 µm et 50 µm afin de réaliser une barrière efficace aux particules alpha entre ladite au moins une source de particules alpha et au moins une zone active dudit dispositif à semiconducteurs, et
(b) une tige conductrice (206) noyée dans ladite couche d'isolement réalisée dans un matériau assurant une ligne électriquement conductrice absorbant des particules alpha entre ledit au moins un plot de contact C4 situé sur un côté de ladite barrière et les couches métalliques dudit dispositif à semiconducteurs situées sur l'autre côté de ladite barrière de particules alpha.

2. Puce de circuit intégré selon la revendication 1, dans laquelle ladite au moins une source de particules alpha comprend en outre un matériau de conditionnement de semiconducteurs en céramique.

3. Puce de circuit intégré selon la revendication 1, dans laquelle ladite au moins une source de particules alpha comprend en outre un matériau d'étanchéité de module à semiconducteurs.

4. Puce de circuit intégré selon l'une quelconque des revendications précédentes dans laquelle le matériau formant ladite tige conductrice est constitué essentiellement de cuivre.

5. Puce de circuit intégré selon l'une quelconque des revendications précédentes, dans laquelle le matériau formant ladite couche d'isolement est constitué essentiellement de quartz ou de polyimide.

6. Puce de circuit intégré selon la revendication 5, dans lequel l'épaisseur de ladite couche d'isolement est 50 µm.

7. Procédé de fabrication d'un module à semiconducteurs qui assure une protection pour la zone active d'un dispositif à semiconducteurs inclus dans ledit module, comprenant les étapes consistant à :
(a) percer au moins un trou dans la couche d'isolement du matériau électriquement isolant, dont l'épaisseur se situe entre 40 µm et 50 µm afin d'assurer une barrière efficace contre les particules alpha entre ladite au moins une source de particules alpha, comportant au moins un plot de contact, et ladite zone active d'un dispositif à semiconducteurs, et
(b) remplir chacun desdits au moins un trou avec une tige électriquement conductrice avec un matériau qui a la propriété d'absorber des particules alpha afin d'assurer une ligne électrique entre ledit plot de contact en contact avec une extrémité de ladite tige et les couches métalliques dudit dispositif à semiconducteurs situées à l'autre extrémité de ladite tige sur le côté opposé de ladite barrière.

8. Procédé selon la revendication 7, dans lequel ladite tige électriquement conductrice est constituée essentiellement de cuivre.

9. Procédé selon l'une quelconque des revendications 7 ou 8 dans lequel ledit matériau électriquement isolant qui absorbe les particules alpha est constitué essentiellement de quartz ou de polyimide.

10. Procédé selon la revendication 9, dans lequel l'épaisseur de ladite couche d'isolement est de 50 µm.
